Europäisches Patentamt

European Patent Office

Office européen des brevets

(11) Veröffentlichungsnummer: **0 279 404 B1**

(12) **EUROPÄISCHE PATENTSCHRIFT**

(45) Veröffentlichungstag der Patentschrift: **06.05.92**

(21) Anmeldenummer: **88102208.1**

(22) Anmeldetag: **15.02.88**

(51) Int. Cl.5: **H01S 3/05**, H01S 3/096, H01S 3/25

(54) **Lasersenderanordnung.**

(30) Priorität: **20.02.87 DE 3705501**

(43) Veröffentlichungstag der Anmeldung:
**24.08.88 Patentblatt 88/34**

(45) Bekanntmachung des Hinweises auf die
Patenterteilung:
**06.05.92 Patentblatt 92/19**

(84) Benannte Vertragsstaaten:
**DE FR GB IT**

(56) Entgegenhaltungen:
**US-A- 4 608 696**

**APPLIED PHYSICS LETTERS, Band 49, Nr. 23,
8. Dezember 1986, Seiten 1575-1577, American Institute of Physics, New York, US; M.
KUNO et al.: "Four-channel AlGaAs/GaAs optoelectronic integrated transmitter array"**

**IEEE JOURNAL OF OUANTUM ELECTRONICS,
Band OE-22, Nr. 6, Juni 1986, Seiten 805-821,
IEEE, New York, US; O. WADA et al.: "Recent progress in optoelectronic integrated circuits (OEIC's)"**

**JOURNAL OF LIGHTWAVE TECHNOLOGY,
Band LT-4, Nr. 6, Juni 1986, Seiten 574-582,
IEEE, New York, US; H. NAKANO et al.:
"Monolithic integration of laser diodes, photomonitors, and laser driving and monitoring circuits on a semi-insulating GaAs"**

**APPLIED PHYSICS LETTERS, Band 36, Nr. 3,
1. Februar 1980, Seiten 181-183, American Institute of Physics, New York, US; T. FUKUZAWA et al.: "Monolithic integration of a GaAlAs injection laser with a Schottky-gate field effect transistor"**

(73) Patentinhaber: **SIEMENS AKTIENGESELLSCHAFT**
**Wittelsbacherplatz 2**
**W-8000 München 2(DE)**

(72) Erfinder: **Kappeler, Franz, Dr.**
**Narzissenstrasse 4**
**W-8039 Puchheim(DE)**
Erfinder: **Heinen, Jochen, Dr.**
**Dianastrasse 38**
**W-8013 Haar(DE)**

## Beschreibung

Die Erfindung betrifft eine Lasersenderanordnung mit mindestens einem Halbleiterlaser und Ansteuerbauelementen.

Für die Nachrichtentechnik sind Lasersender mit lateral gekoppelten Halbleiterlasern wegen ihrer dynamischen Einfrequenzeigenschaften wichtig. Aufbau und Funktion derartiger gekoppelter Halbleiterlaser sind in der europäischen Patentschrift Nr. 01 49 042 A2 beschrieben. Eine Anordnung von teilweise lateral verkoppelten Halbleiterlasern mit getrennt ansteuerbaren Elektroden stellt einen für nachrichtentechnische Zwecke günstigen Lasersender mit dynamischen Einfrequenzeigenschaften dar. Zum Einstellen des Betriebspunktes werden die einzelnen Laser mit bestimmten Betriebsströmen versorgt. Die dafür erforderlichen Ansteuerbauelemente werden als Einzelbauelemente zu den Halbleiterlasern zugeschaltet.

Im Stand der Technik existieren eine Reihe von Kombinationen eines oder mehrerer Halbleiterlaser mit diversen Ansteuerbauelementen. In der DE-OS 3 124 633 A1 ist ein Halbleiterlaser beschrieben, bei dem in die auf ein Substrat aufgewachsene Halbleiterschichtfolge ein Transistor zum Ansteuern des Halbleiterlasers integriert ist. Die Besonderheit dieses Aufbaues besteht darin, daß in der obersten Halbleiterschicht ein Graben mit V-förmigem Querschnitt ausgespart ist, der mit Halbleitermaterial des entgegengesetzten Leitungstyps aufgefüllt ist. Auf der Oberfläche befinden sich nur verschiedene Kontakte für den Anschluß von Elektroden.

In der Druckschrift GB 2 144 912 A ist ein Aufbau mit einer Laserdiode und Ansteuerbauelementen, von denen in einem Ausführungsbeispiel zwei Transistoren und eine Induktivität angegeben sind, beschrieben. Die Laserdiode und die Ansteuerbauelemente sind auf einer Platine aus Keramik montiert, die in einem Gehäuse befestigt ist. Das wesentliche hierbei ist nicht der Aufbau an sich, sondern die Funktion der in diesem Aufbau zusammengeschalteten Elemente.

In der Druckschrift JP 58-100 480 ist ein Halbleiterlaseraufbau beschrieben, bei dem zusätzliche Halbleiterschichten für die Integration eines Transistors zum Ansteuern der Laserdiode vorgesehen sind.

In der Druckschrift JP 61-444 87 ist ein Aufbau beschrieben, bei dem ein Halbleiterlaserchip zusammen mit einem Schaltkreis zum Schutz gegen Überspannung auf einem gemeinsamen Substrat befestigt und mit einem Golddraht leitend verbunden sind. In der Druckschrift JP 61-262 77 ist ein Halbleiterlaserchip mit drei integrierten Feldeffekttransistoren beschrieben. Die Funktionselemente dieses Aufbaues befinden sich in vertikaler Anordnung auf einem GaAs-Substrat; die Feldeffekttransistoren im unteren und die Laserdiode im oberen Teil. Ein ähnlicher Aufbau eines Halbleiterlasers mit integriertem Feldeffekttransistor, wobei dieser Feldeffekttransistor im unteren Teil einer Halbleiterschichtstruktur und die Laserdiode in den oberen Halbleiterschichten ausgebildet ist, ist beschrieben von I. Ury und K. Y. Lau in "Appl. Phys. Lett." 41, 126 bis 128 (1982). T. Fukuzawa e.a. geben in "Appl. Phys. Lett." 36, 181 bis 183 (1980) einen Halbleiterlaseraufbau mit monolithisch integriertem Feldeffekttransistor an, bei dem sowohl Laser als auch FET nebeneinanderliegend an der Oberfläche einer Halbleiterschichtstruktur ausgebildet sind. Der FET dient auch hier dem Ansteuern des Lasers.

In H. Nakano e. a.: "Monolithic Integration of Laser Diodes, Photomonitors, and Laser Driving and Monitoring Circuits on a Semi-Insulating GaAs", J. of Lightwave Technology LT-4, 574 bis 582 (1986) ist die monolithische Integration von Laser-und Fotodioden mit Schaltkreisen angegeben. Diese Schaltkreise dienen zum Ansteuern des Lasers und zur Rückkopplung zur Kontrolle der Strahlungsintensität. Sie bestehen aus Feldeffekttransistoren und Widerständen und sind an der Oberfläche des FET's aufgebracht. Über diese Steuerschaltkreise werden nur eine Laserdiode und eine Fotodiode betrieben, während zum Vergleich eine zweite Laserdiode und eine zweite Fotodiode vorgesehen sind, die ohne Steuerschaltkreise betrieben werden. Der Unterschied zu den vorher zitierten Druckschriften besteht darin, daß eine größere Anzahl von elektronischen Funktionselementen monolithisch in das Halbleiterbauelement integriert ist und die Schaltungen einen komplexeren Aufbau aufweisen.

Aufgabe der vorliegenden Erfindung ist es, einen für vereinfachte Herstellung und einfache Dimensionierbarkeit der Ansteuerbauelemente vorteilhaften Aufbau einer mit möglichst wenigen Spannungsquellen ansteuerbaren Lasersenderanordnung anzugeben.

Diese Aufgabe wird erfindungsgemäß mit einer Lasersenderanordnung gelöst, die die Merkmale des Patentanspruchs 1 aufweist. Die weitere Ausgestaltung der Erfindung ergibt sich aus den Unteransprüchen.

Im allgemeinen ist für jeden Laser eine Stromquelle vorzusehen. Die Stromspeisung kann auch durch Hinzufügen von Vorwiderständen im geeigneten Verhältnis mit weniger Stromquellen, als Laser vorhanden sind, erfolgen, bestenfalls mit einer einzigen Stromquelle. Im Betrieb wird wenigstens ein Laser zusätzlich mit einem modulierten Signalstrom beaufschlagt. Zum Abblocken der Signalquelle gegen die Gleichstromversorgung wird einerseits eine Kapazität als niederfrequente Sperre und zum Abblocken der hochfrequenten Signale gegen die Gleichstromversorgung eine Induktivität als hochfrequente Sperre benötigt.

Bei dem erfindungsgemäßen Aufbau werden diese Ansteuerbauelemente als auf die Oberfläche des Bauelementes aufgebrachte Leiterbahnen ausgebildet und so in das Bauelement integriert. Weitere Vorteile der Erfindung sind u. a., daß die neue Lasersenderanordnung verbesserte Hochfrequenzeigenschaften hat und einfacher zu reproduzieren ist.

In den folgenden Fig. 1 bis 3 wird die Erfindung anhand eines Ausführungsbeispiels weiter erläutert.

Fig. 1 zeigt das Schaltbild einer möglichen Lasersenderschaltung mit vier Halbleiterlasern 1, 2, 3 und 4.

Fig. 2 zeigt ein Ausführungsbeispiel einer solchen Lasersenderanordnung in Aufsicht.

Fig. 3 zeigt einen Schnitt der Lasersenderanordnung an der in Fig. 2 mit III-III bezeichneten Stelle.

Der Halbleiterlaser 4 wird mit dem Signal einer Hochfrequenzsignalquelle 12 beaufschlagt. Um eine Gleichstromquelle 11 und die Hochfrequenzsignalquelle 12 gegeneinander abzuschirmen, wird auf der Seite der Gleichstromquelle eine Induktivität 9 und auf der Seite der Hochfrequenzsignalquelle eine Kapazität 10 zwischengeschaltet. Die Vorwiderstände 5, 6, 7 und 8 dienen dazu, die Betriebsströme der jeweils damit verbundenen Halbleiterlaser 1,2,3,4 einzustellen.

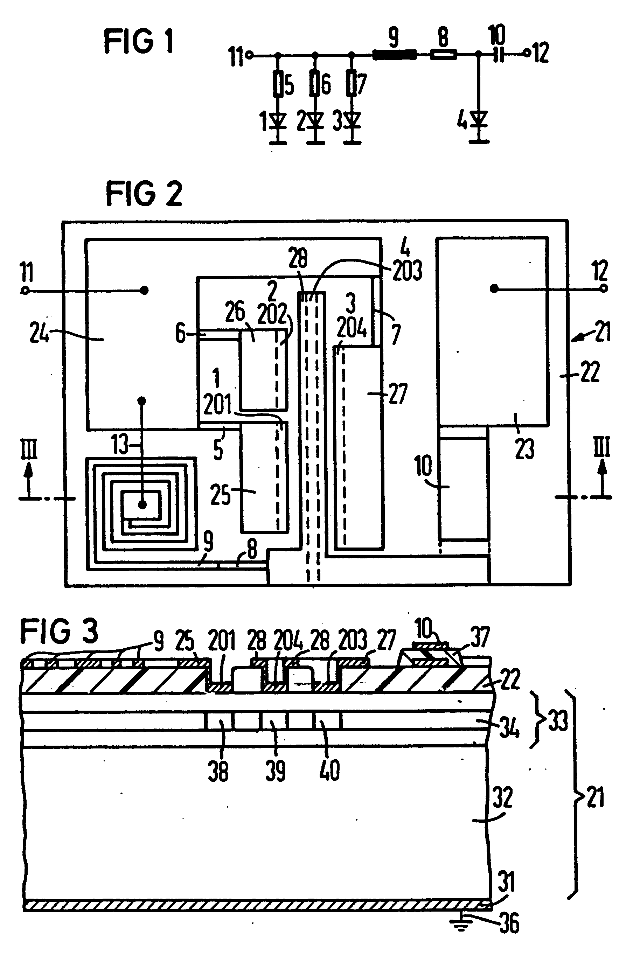

Fig. 2 zeigt das Schema des Aufbaus der Halbleiterlaser und Ansteuerbauelemente für das Schaltbild aus Fig. 1. Im mittleren Bereich der Oberfläche eines Halbleiterkörpers 21 befinden sich Kontaktflächen 25, 26, 27 und 28 der Halbleiterlaser. Sie sind mit den jeweiligen streifenförmigen leitenden Belegungen für die aktiven Laserstreifen 201, 202, 204 und 203 verbunden, die tiefer im Halbleiterkörper 21 liegen (s. Fig. 3). Die Verbindung der Halbleiterlaser 1,2,3,4 mit den Ansteuerbauelementen erfolgt über ihre Kontaktflächen 25,26,27,28. Die Vorwiderstände 5, 6, 7 und 8 bestehen aus Leiterbahnen. Ihre Dimensionierung ist gegeben durch die Leitfähigkeit der Leiterbahn, die durch Länge, Breite, Höhe und Material und Schichtung einstellbar ist. Zur Feinabstimmung kann im Betrieb z.B. mit Hilfe von Laserstrahlen Leiterbahnmaterial entfernt werden.

Die Induktivität 9 ist als spiralförmige Leiterbahn hergestellt. Sie ist durch Länge, Breite der Leiterbahn und Bahnabstand bestimmt und kann auch ganz oder teilweise die Funktion des Vorwiderstandes 8 mit übernehmen. Die Verbindung der Induktivität 9 mit der Gleichstromquelle 11 ist hier durch Kontaktierung eines Verbindungsdrahtes 13 (z.B. Gold und Aluminium) zur Kontaktierfläche für Gleichstromanschluß 24 hergestellt.

Der Aufbau der Kapazität 10 wird später anhand Fig. 3 beschrieben. Die Kontaktierfläche 24 für den Gleichstromanschluß 11 und die Kontaktierfläche 23 für den Hochfrequenzanschluß 12 liegen im Randbereich der Oberfläche des Halbleiterkörpers 21 zur Erleichterung der Kontaktierung.

Der Halbleiterkörper 21 besteht aus einer Metallschicht 31, einer Substratschicht 32 und epitaktisch abgeschiedenen Schichten 33. Auf der Unterseite der Substratschicht 32 ist die Metallschicht 31 aufgebracht, die zur Befestigung auf einem Kühlkörper durch Legieren dient. In den epitaktisch abgeschiedenen Schichten 33 befindet sich eine aktive Laserschicht 34. Darin entstehen die aktiven Laserstreifen 38,35,39 und 40 (der aktive Laserstreifen 35 ist in diesem Schnitt nicht sichtbar) bei Stromzufuhr durch die streifenförmigen leitenden Belegungen 201, 202, 203 und 204. Die aktiven Laserstreifen 38, 35,39,40 sind verschieden lang und liegen mit ihren optischen Achsen parallel zueinander im Halbleiterkörper 21. Damit wird die bekannte laterale Kopplung mit dynamischer Einfrequenzeigenschaft erreicht. Auf den epitaktisch abgeschiedenen Schichten 33 und zwischen den streifenförmigen leitenden Belegungen 201,202,203,204 befindet sich eine Isolierschicht 22 (z.B. Oxid- oder Nitridschicht). Die Kontaktflächen der Halbleiterlaser 25, 26, 27 und 28 befinden sich auf der Isolierschicht 22 und sind durch diese hindurch mit den streifenförmigen leitenden Belegungen 201, 202, 203 und 204 verbunden. Die Ansteuerbauelemente 5,6,7,8,9,10 und die Kontaktierflächen 23,24 für die Gleichstromquelle 11 und die Hochfrequenzsignalquelle 12 sind auf der Isolierschicht 22 angebracht. Die Kapazität 10 besteht aus zwei übereinanderliegenden Leiterbahnen mit dazwischenliegendem Dielektrikum 37 (z.B. Siliziumoxid, Aluminiumoxid oder Siliziumnitrid).

Art, Fläche und Dicke des Dielektrikums 10 können als Einstellgröße für die Kapazität verwendet werden. Der Masseanschluß der Schaltung ist durch den Kontakt der Metallschicht 31 mit dem Kühlkörper hergestellt.

**Patentansprüche**

1. Lasersenderanordnung mit einer Substratschicht (32) aus III-V-Halbleitermaterial, mit darauf epitaktisch abgeschiedenen Schichten (33) mit strahlungserzeugendem pn-Übergang, mit mindestens einem Laserstreifen (38, 39, 40) mit zugehöriger leitender Belegung (201, 202, 203, 204) und Kontaktfläche (25, 26, 27, 28) und mit mindestens einem aus einem Leiter gebildeten Widerstand als Ansteuerbauelement (5, 6, 7, 8), das auf der die Kontaktfläche (25, 26, 27, 28) aufweisenden Oberfläche der Lasersenderanordnung angebracht und gegenüber dem Halbleitermaterial der epitaktisch abgeschiedenen Schichten (33) elektrisch isoliert ist, **dadurch gekennzeichnet,**

- daß mindestens eine Kapazität (9) und mindestens eine Induktivität (10) als weitere Ansteuerbauelemente vorhanden sind,
- daß die vorgegebene elektrische Dimensionierung jedes Ansteuerbauelementes (5, 6, 7, 8, 9, 10) sowohl durch das verwendete Leitermaterial als auch durch die geometrische Abmessung gegeben ist und
- daß der ein jeweiliges weiteres Ansteuerbauelement (9, 10) bildende Leiter eine Leiterbahn ist, die unmittelbar auf der Oberfläche der Lasersenderanordnung aufgebracht ist.

2. Lasersenderanordnung nach Anspruch 1, **dadurch gekennzeichnet,**

- daß jede Induktivität (9) als spiralförmig aufgebrachte Leiterbahn ausgebildet ist,
- daß jede Kapazität (10) aus zwei übereinanderliegenden Leiterbahnen oder Leiterschichten mit dazwischenliegendem Dielektrikum (37) besteht,
- daß jeder Induktivität (9) ein Vorwiderstand (8) zugeordnet ist und jede Induktivität (9) mit der Kontaktfläche (28) mindestens eines Laserstreifens (39) verbunden ist,
- daß die eine Leiterbahn jeder Kapazität (10) mit einer ersten Kontaktierfläche (23) verbunden ist,
- daß die jeweils andere Leiterbahn der betreffenden Kapazität (10) jeweils mit der Kontaktfläche (28) eines Laserstreifens (39) verbunden ist,
- daß zu jeder Kapazität (10) eine Induktivität (9), die jeweils mit der mit der einen Leiterbahn dieser Kapazität (10) verbundenen Kontaktfläche (28) verbunden ist, vorgesehen ist und
- daß jede Induktivität (9) mit einer zweiten Kontaktierfläche (24) verbunden ist.

3. Lasersenderanordnung nach Anspruch 1 oder 2 mit mindestens zwei Laserstreifen (38, 39, 40), **dadurch gekennzeichnet,**

- daß für jede leitende Belegung (201, 202, 203, 204) der Laserstreifen (38, 39, 40) als Ansteuerbauelement ein mit der zugehörigen Kontaktfläche (25, 26, 27, 28) verbundener Vorwiderstand (5, 5, 7, 8) vorgesehen ist,
- daß ein Teil dieser Vorwiderstände (5, 6, 7) direkt mit der zweiten Kontaktierfläche (24) verbunden ist und
- daß die übrigen Vorwiderstände (8) über eine Induktivität (9) mit der zweiten Kontaktierfläche (24) verbunden sind.

4. Lasersenderanordnung nach Anspruch 3 oder 4, **dadurch gekennzeichnet,** daß die Laserstreifen (38, 39, 40) parallel verlaufen und lateral verkoppelt sind.

5. Lasersenderanordnung nach einem der Ansprüche 1 bis 5, **dadurch gekennzeichnet,** daß die Ansteuerbauelemente (5, 6, 7, 8, 9, 10) von den epitaktisch abgeschiedenen Schichten (33) aus Halbleitermaterial durch eine Isolierschicht (22) elektrisch isoliert sind.

6. Lasersenderanordnung nach einem der Ansprüche 2 bis 5, **dadurch gekennzeichnet,** daß mindestens ein einer Induktivität (9) zugeordneter Vorwiderstand durch den ohmschen Widerstand der Induktivität (9) selbst gebildet wird.

7. Lasersenderanordnung nach einem der Ansprüche 1 bis 6, **dadurch gekennzeichnet,** daß wenigstens einer der Vorwiderstände (8) durch die Bemessung der jeweiligen Leiterbahn gegeben ist.

**Claims**

1. Laser transmitter arrangement comprising a substrate layer (32) of III-V semiconductor material having layers (33) epitaxially deposited thereupon with a radiation-generating pn-junction, comprising at least one laser strip (38, 39, 40) having an appertaining conductive coating (201, 202, 203, 204) and a contact surface (25, 26, 27, 28), and comprising at least one resistor, formed from a conductor, as a drive component (5, 6, 7, 8) which is mounted on the surface of the laser transmitter arrangement having the contact surface (25, 26, 27, 28) and is electrically insulated from the semiconductor material of the epitaxially deposited layers (33), characterised in that

- at least one capacitor (9) and at least one inductor (10) are present as further drive components,
- the prescribed electrical dimensioning of each drive component (5, 6, 7, 8, 9, 10) is given both by the conductive material employed and by the geometrical dimensioning, and
- the conductor forming a respective further drive component (9, 10) is an interconnect which is applied directly to the surface of the laser transmitter arrangement.

2. Laser transmitter arrangement according to Claim 1, characterised in that
- each inductor (9) is constructed as an interconnect applied in the form of a spiral, and
- each capacitor (10) consists of two superimposed interconnects or conductive layers with a dielectric (37) therebetween,
- each inductor (9) is assigned a series resistor (8), and each inductor (9) is connected to the contact surface (28) of at least one laser strip (39),
- one interconnect of each capacitor (10) is connected to a first contacting surface (23),
- the respective other interconnect of the relevant capacitor (10) is connected in each case to the contact surface (28) of a laser strip (39),
- each capacitor (10) is provided with an inductor (9) which is connected in each case to the contact surface (28) connected to one interconnect of this capacitor (10), and
- each inductor (9) is connected to a second contacting surface (24).

3. Laser transmitter arrangement according to Claim 1 or 2 comprising at least two laser strips (38, 39, 40), characterised in that
- a series resistor (5, 6, 7, 8) connected to the appertaining contact surface (25, 26, 27, 28) is provided for each conductive coating (201, 202, 203, 204) of the laser strips (38, 39, 40) as a drive component,
- some of these series resistors (5, 6, 7) are connected directly to the second contacting surface (24), and
- the remaining series resistors (8) are connected via an inductor (9) to the second contacting surface (24).

4. Laser transmitter arrangement according to Claim 3 or 4, characterised in that the laser strips (38, 39, 40) extend in parallel and are laterally coupled.

5. Laser transmitter arrangement according to one of Claims 1 to 5, characterised in that the drive components (5, 6, 7, 8, 9, 10) are electrically insulated by an insulating layer (22) from the epitaxially deposited layers (33) of semiconductor material.

6. Laser transmitter arrangement according to one of Claims 2 to 5, characterised in that at least one series resistor assigned to an inductor (9) is formed by the ohmic resistance of the inductor (9) itself.

7. Laser transmitter arrangement according to one of Claims 1 to 6, characterised in that at least one of the series resistors (8) is given by the dimensioning of the respective interconnect.

## Revendications

1. Dispositif émetteur laser comportant une couche formant substrat (32) formée d'un matériau III-V et sur laquelle sont déposées, par épitaxie, des couches (33) possédant une jonction pn émettant un rayonnement, et comportant au moins une bande laser (38,39,40) à laquelle est associé un revêtement conducteur (201,202,203,204) possédant une surface de contact (25,26,27,28) et comportant au moins une résistance formée par un conducteur et constituant un composant de commande (5,6,7,8), qui est disposé sur la surface du dispositif émetteur laser, qui comporte la surface de contact (25,26,27,28) et est isolé électriquement par rapport au matériau semiconducteur des couches (33) déposées par épitaxie, caractérisé par le fait
- qu'au moins une capacité (9) et au moins une inductance (10) sont présentes en tant qu'autres éléments de commande,
- que le dimensionnement électrique prédéterminé de chaque composant de commande (5,6,7,8,9,10) est déterminé aussi bien par le matériau utilisé pour le conducteur que par le dimensionnement géométrique, et
- que le conducteur, qui forme un autre composant respectif de commande (9,10), est une voie conductrice qui est déposée directement sur la surface du dispositif émetteur laser.

2. Dispositif émetteur laser suivant la revendication 1, caractérisé par le fait
   - que chaque inductance (9) est réalisée sous la forme d'une voie conductrice déposée en spirale,
   - que chaque capacité (10) est constituée de deux voies conductrices ou couches conductrices superposées entre lesquelles est intercalé un diélectrique (37),
   - qu'à chaque inductance (9) est associée une résistance additionnelle (8) et que chaque inductance (9) est raccordée à la surface de contact (28) d'au moins une bande laser (39),
   - qu'une voie conductrice de chaque capacité (10) est raccordée à une première surface de contact (23),
   - que l'autre voie conductrice respective de la capacité considérée (10) est raccordée respectivement à la surface de contact (28) d'une bande laser (39),
   - que pour chaque capacité (10) il est prévu une inductance (9) qui est raccordée respectivement à la surface de contact (28) raccordée à une voie conductrice de cette capacité (10), et
   - que chaque inductance (9) est raccordée à une seconde surface de contact (24).

3. Dispositif émetteur laser suivant la revendication 1 ou 2, comportant au moins deux bandes laser (38,39,40),
   caractérisé par le fait
   - que pour chaque revêtement conducteur (201,202,203,204) des bandes laser (38,39,40) il est prévu, comme composant de commande, une résistance additionnelle (5,7,8) raccordée à la surface de contact associée (25,26,27,28),
   - qu'une partie de ces résistances additionnelles (5,6,7) est raccordée directement à la seconde surface de contact (24), et
   - que les autres résistances additionnelles (8) sont raccordées par l'intermédiaire d'une inductance (9) à la seconde surface de contact (24).

4. Dispositif émetteur laser suivant la revendication 3 ou 4, caractérisé par le fait que les bandes laser (38,39,40) sont parallèles et accouplées latéralement.

5. Dispositif émetteur laser suivant l'une des revendications 1 à 5, caractérisé par le fait que les composants de commande (5,6,7,8,9,10) sont isolés électriquement vis-à-vis des couches (33) déposées par épitaxie et formées d'un matériau semiconducteur, par une couche isolante (22).

6. Dispositif émetteur laser suivant l'une des revendications 2 à 5, caractérisé par le fait qu'au moins une résistance additionnelle associée à une inductance (9) est formée par la résistance ohmique de l'inductance (9) ellemême.

7. Dispositif émetteur laser suivant l'une des revendications 1 à 6, caractérisé par le fait qu'au moins l'une des résistances additionnelles (8) est déterminée par le dimensionnement de la voie conductrice respective.

FIG 1

FIG 2

FIG 3